(19) Europäisches Patentamt / European Patent Office / Office européen des brevets

(11) **EP 2 837 714 B1**

(12) **FASCICULE DE BREVET EUROPEEN**

(45) Date de publication et mention
de la délivrance du brevet:
**04.05.2016 Bulletin 2016/18**

(21) Numéro de dépôt: **14180669.5**

(22) Date de dépôt: **12.08.2014**

(51) Int Cl.:
*C23C 14/02* [(2006.01)]  *C23C 16/02* [(2006.01)]
*C30B 25/02* [(2006.01)]  *C30B 25/18* [(2006.01)]
*C30B 29/16* [(2006.01)]  *C23C 16/40* [(2006.01)]
*C23C 14/08* [(2006.01)]

(54) **Procédé de réalisation d'une couche texturée d'oxyde de fer spinelle**

Verfahren zur Herstellung einer strukturierten Eisenoxidschicht vom Typ Spinell

Method for producing a textured layer of spinel iron oxide

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.08.2013 FR 1358036**

(43) Date de publication de la demande:
**18.02.2015 Bulletin 2015/08**

(73) Titulaire: **COMMISSARIAT A L'ENERGIE
ATOMIQUE ET AUX
ENERGIES ALTERNATIVES
75015 Paris (FR)**

(72) Inventeurs:
• **Zucchi, Xavier
38410 Vaulnaveys-le-haut (FR)**
• **Guillaumont, Marc
38000 Grenoble (FR)**

(74) Mandataire: **Hautier, Nicolas
Cabinet Hautier
20, rue de la Liberté
06000 Nice (FR)**

(56) Documents cités:
• **KOSUKE MATSUZAKI ET AL: "Fast Track
Communication;Fe3O4(1 1 1) thin films with
bulk-like properties: growth and atomic
characterization;Fe3O4(1 1 1) thin films with
bulk-like properties: growth and atomic
characterization", JOURNAL OF PHYSICS D:
APPLIED PHYSICS, INSTITUTE OF PHYSICS
PUBLISHING LTD, GB, vol. 46, no. 2, 5 décembre
2012 (2012-12-05), page 22001, XP020236119,
ISSN: 0022-3727, DOI:
10.1088/0022-3727/46/2/022001**
• **LAZAROV ET AL.: "Polar oxide interface
stabilization by formation of metallic
nanocrystals", PHYSICAL REVIEW LETTERS,
vol. 90, no. 21, 30 mai 2008 (2008-05-30), pages
216108-1-216108-4, XP002722355,**
• **M. RITTER ET AL: "Fe3O4(111) surface structure
determined by LEED crystallography", SURFACE
SCIENCE, vol. 432, no. 1-2, 1 juillet 1999
(1999-07-01), pages 81-94, XP055109004, ISSN:
0039-6028, DOI: 10.1016/S0039-6028(99)00518-X**

**Description**

DOMAINE TECHNIQUE DE L'INVENTION

La présente invention concerne en général la texturation de matériaux utilisés par l'industrie de la microélectronique et des microsystèmes et plus particulièrement la texturation d'oxydes de fer spinelle.

ÉTAT DE LA TECHNIQUE

Pour de nombreuses applications en microélectronique et plus généralement pour la réalisation de microsystèmes l'obtention d'une texturation des matériaux utilisés est souvent recherchée.

On entend ici par texturation le caractère ordonné de la structure cristallographique que peuvent acquérir ces matériaux. L'exemple le plus commun est le silicium dont les propriétés physiques et électriques diffèrent notablement entre ses états : monocristallin, où une seule orientation cristalline est présente ; polycristallin, où les grains d'un échantillon polycristallin peuvent présenter une orientation cristalline marquée mais où ceux-ci peuvent aussi être orientés aléatoirement les uns par rapport aux autres comme dans le cas d'une poudre ; et enfin amorphe, où aucune orientation cristalline n'est détectable, l'état amorphe correspondant au cas où le matériau n'est pas du tout cristallisé.

Une gamme de matériaux qui est susceptible de convenir à de nombreuses applications en microélectronique est celle des oxydes de fer qui existent sous différentes formes chimiques. Une partie d'entre eux, couramment désignés comme étant des oxydes de fer spinelle, se sont avérés être plus particulièrement aptes à la mise en oeuvre de dispositifs divers tels que les mémoires non volatiles (FeRAM), les mémoires résistives à pont conducteur (CBRAM), les photodétecteurs infrarouge, et pour d'autres applications tirant profit de leur caractère magnétique, par exemple la spintronique.

Il s'agit plus précisément de la magnétite dont la composition chimique est $Fe_3O_4$ et de la maghémite de composition chimique $Fe_2O_3$ dans sa phase dite gamma ($\gamma$-$Fe_2O_3$).

La texturation d'une couche d'oxyde de fer spinelle permet de conférer des propriétés qui sont susceptibles d'améliorer grandement le fonctionnement des dispositifs dans lesquels ces couches sont utilisées.

Pour la plupart des oxydes de fer spinelles ($Fe_3O_4$ par exemple) la direction de croissance à privilégier, dans le cadre des applications dans le magnétisme, est la direction cristalline [111] (ou <111> si on prend en compte l'ensemble de la famille de directions). Les coefficients entre crochets représentent les indices de direction. On pourra également parler de texture (111) (ou {111} si on prend en compte l'ensemble de la famille de plans cristallins), où les indices entre parenthèses sont les indices de Miller, qui est une manière de désigner des plans dans un cristal.

Ces notations, en utilisant les indices de direction et indices de Miller, sont très largement utilisées par toute l'industrie de la microélectronique et sont bien connues de l'homme de métier.

En effet, la direction [111] est appelée "axe de facile aimantation" dans la littérature, axe suivant lequel il sera plus facile d'aligner l'aimantation, pour ces composés.

Le tableau ci-après donne les propriétés physiques de la magnétite et la maghémite utiles à la compréhension de l'invention.

| | Magnétite $Fe_3O_4$ | Maghémite $\gamma$-$Fe_2O_3$ |
|---|---|---|
| Paramètre de maille en nm ($10^{-9}$ mètre) : | 0,8936 | 0,83474 |
| Densité | 5,18 | 4,87 |
| Type et résistivité à 300°K en Ohm.cm : | Semi-conducteur $5\times10^{-3}$ | Isolant $1\times10^{19}$ |
| Type de magnétisme : | Ferrimagnétique | Ferrimagnétique |

La magnétite et la maghémite peuvent être formées suivant de nombreuses techniques connues et notamment :

- par oxydation de phases moins oxydées (Fe ou FeO) ;
- par MBE, acronyme de l'anglais « molecular beam epitaxy » c'est-à-dire « épitaxie par jets moléculaires » qui est une technique consistant à envoyer un ou plusieurs jets moléculaires vers un substrat préalablement choisi pour réaliser une croissance épitaxiale ;
- par PLD, acronyme de l'anglais « pulsed laser déposition » qui est une méthode de dépôt en couches minces utilisant un laser de très forte puissance aussi appelée « ablation laser pulsé » et qui permet de pulvériser les atomes d'une cible qui vont se condenser sur un substrat;
- par pulvérisation cathodique magnétron ;
- par IBD, acronyme de l'anglais « ion beam déposition » c'est-à-dire « dépôt par faisceau ionique » ;

- par spray pyrolyse ultrasonique selon la technique dite « sol-gel ».

Afin d'obtenir une couche texturée de magnétite ou de maghémite les solutions connues prévoient de partir de sous-couches faites de matériaux tels que : le saphir (Al$_2$O$_3$) ; le silicium (Si) ; l'arséniure de gallium (GaAs) ; le cuivre (Cu) ; le ruthénium (Ru) ; le titanate de strontium SrTiO$_3$ ; l'oxyde de zinc (ZnO) ; le platine (Pt) et en particulier l'oxyde de magnésium (MgO).

Par exemple, la publication portant le titre « Atomic and electronic structure of the Fe3O4(111)/MgO(111) model polar oxide interface» par V. K. Lazarov, M. Weinert, S. A. Chambers, M. Gajdardziska-Josifovska, parue en 2005 dans la revue « Physical Review B 72 » 195401 1-7 publiée par « The American Physical Society », préconise d'obtenir une couche de magnétite (Fe$_3$O$_4$) dont la structure cristalline est orientée (111) par croissance épitaxiale à partir d'une couche d'oxyde de magnésium (MgO).

On notera que pour obtenir la texturation de la magnétite, la sous-couche d'oxyde de magnésium doit être monocristalline, d'orientation (111). Cela implique nécessairement des contraintes en termes de procédé.

En particulier, cette solution nécessite d'obtenir un substrat épais (« bulk substrate » en anglais) monocristallin d'oxyde de magnésium, ce qui est onéreux et conduit en pratique à limiter la taille du substrat. De plus il est impossible d'obtenir des empilements complexes ou de type « MEMS », acronyme de l'anglais « microelectromechanical systems » qui désigne des microsystèmes électro mécaniques, et aucun équipement conventionnel de microélectronique ne peut définir des motifs sur ce type de substrat.

Une solution alternative consiste à utiliser une couche mince texturée (111) au contact de la couche d'oxyde de fer spinelle. Néanmoins, cela nécessite d'orienter au préalable cette couche mince à l'aide de substrats cristallins sous-jacents eux-mêmes soigneusement orientés. Cette solution alternative est donc également onéreuse et présente toujours des problèmes au niveau de la réalisation d'empilements complexes et MEMS même si la définition de motifs par des équipements conventionnels est alors cependant possible.

On notera aussi que pour obtenir la texturation de la couche d'oxyde de magnésium (MgO) avec une orientation cristalline (111) il faut mettre en oeuvre des températures élevées dans une gamme allant de 500°C à 800°C. Ces températures sont incompatibles avec la présence d'un circuit sous-jacent à la couche d'oxyde de fer spinelle.

Le circuit sous-jacent est typiquement un circuit intégré (IC), par exemple de type CMOS, acronyme de l'anglais « complementary metal-oxide-semiconductor », désignant le type de circuits électroniques le plus couramment produit actuellement par l'industrie de la microélectronique.

La texturation devant être réalisée dans une couche située au-dessus d'un circuit et nécessitant des températures allant de 500°C à 800°C, la fabrication du dispositif devient alors très complexe et donc très coûteuse. En effet, il faudrait alors mettre en oeuvre des procédés de report de couches elles-mêmes préalablement structurées pour obtenir ce résultat. Ce d'autant plus que le circuit intégré est lui-même déjà interconnecté, c'est-à-dire a passé les étapes de fabrication dites de « BEOL », acronyme de l'anglais « back-end of line » et qu'il n'est plus possible de mettre en oeuvre des températures élevées qui risqueraient donc de l'endommager.

Il existe donc un besoin consistant à limiter voire à supprimer certains au moins des inconvénients des solutions connues pour obtenir une couche d'oxyde de fer spinelle texturée selon la direction de croissance [111].

RÉSUMÉ DE L'INVENTION

Pour atteindre cet objectif, un aspect de la présente invention concerne un procédé de réalisation d'une couche d'oxyde de fer spinelle (également appelé oxyde de fer à structure spinelle), texturée selon une orientation cristalline préférentielle suivant la direction [111], la couche d'oxyde de fer spinelle étant une couche de ferrite ou une couche de ferrite dopée. Le procédé comprend la réalisation d'une couche basale de titane (Ti) ou d'oxyde de titane (TiO$_x$), dont l'épaisseur est avantageusement supérieure ou égale à huit nanomètres, puis la réalisation d'une couche d'oxyde de fer spinelle sur ladite couche basale.

On s'est aperçu dans le cadre de développement de la présente invention que la couche d'oxyde de fer spinelle présente une excellente texturation lorsqu'elle est déposée sur une couche basale de titane (Ti) ou d'oxydes de titane (TiO$_x$).

De manière surprenante, cette texturation de la couche d'oxyde de fer spinelle suivant la direction [111] est obtenue alors même que la couche basale ne présente pas une orientation cristalline préférentielle suivant la direction [111]. Obtenir une structure cubique face centrées pour la couche d'oxyde de fer spinelle à partir d'une couche basale présentant une structure cristalline très différente (structure hexagonale pour le titane et tetragonale pour le TiO$_2$) n'est clairement pas prévisible. Par ailleurs, les paramètres de maille de la ferrite et de la couche basale sont peu compatibles, a priori, ce qui rend le résultat de l'invention encore plus étonnant. Il semblerait que cette excellente texturation soit une tendance naturelle, les grains de la magnétite ou de la maghémite s'arrangeant par rapport à la couche basale de titane (Ti) ou d'oxyde de titane (TiO$_x$).

Il n'est alors pas nécessaire de prévoir un substrat épais texturé, tel qu'un substrat de MgO. Il n'est pas non plus nécessaire de préparer une fine couche texturée. L'invention permet ainsi d'atténuer voire de supprimer les inconvénients des solutions connues pour obtenir une couche texturée de ferrite. En particulier, la nature de la couche de Ti ou TiO$_x$ est indépendante de la couche N-2 (couche avant dépôt du TiO$_2$), ce qui permet d'insérer ces oxydes de fer texturés dans n'importe quelle étape d'un procédé classique de microélectronique ou lors de l'obtention de structure complexes de type MEMS. Les démonstrateurs ont été effectués sur une sous-couche amorphe et cristalline.

Le coût d'obtention d'une telle couche est ainsi considérablement réduit.

Par ailleurs, la texturation de la couche de ferrite obtenue avec l'invention dépend peu de l'orientation préférentielle de la couche basale, ce qui permet de réduire encore plus les contraintes de procédé.

De façon très avantageuse, le procédé selon l'invention n'est que peu sensible aux conditions de dépôt de la couche d'oxyde de fer spinelle et de la couche basale. L'invention permet ainsi d'élargir fortement la fenêtre du procédé.

De façon également avantageuse, l'invention dépend faiblement des matériaux sous-jacents à la couche basale. Elle peut donc être mise en oeuvre dans un grand nombre de dispositifs.

Un autre aspect très avantageux réside dans le fait que le pouvoir texturant conféré par la couche basale est obtenu même s'il n'y a pas de contact direct entre cette dernière et la couche d'oxyde de fer spinelle. Mieux encore ce pouvoir texturant dépend peu de la nature de la couche intermédiaire au contact de la ferrite, tant que cette couche intermédiaire n'est pas amorphe. Cela permet d'utiliser des matériaux intermédiaires variés, par exemple des matériaux conducteurs ou au contraire isolants, afin de répondre aux contraintes de l'application concernée.

De façon également très avantageuse, le procédé de l'invention ne requiert pas l'application de températures élevées pour obtenir la couche de ferrite texturée. Ce procédé reste ainsi parfaitement compatible avec les techniques habituelles de l'industrie de la microélectronique CMOS.

De manière facultative, le procédé selon l'invention peut en outre présenter au moins l'une quelconque des caractéristiques suivantes :

- Avantageusement, l'épaisseur de la couche basale est supérieure ou égale à 10 nanomètres, de préférence supérieure ou égale à 15 nanomètres et avantageusement supérieure ou égale à 20 nanomètres. L'épaisseur est prise selon une direction perpendiculaire aux faces principales du substrat sur lequel repose les différentes couches. Si la couche basale présente des faces formant des disques, alors son épaisseur est prise perpendiculairement à ces faces.

- Selon un mode de réalisation, la couche d'oxyde de fer spinelle est une couche de magnétite (Fe$_3$O$_4$) ou une couche de maghémite (Fe$_2$O$_3$) ou un mélange de magnétite (Fe$_3$O$_4$) et de maghémite (Fe$_2$O$_3$). Selon un autre mode de réalisation, la couche d'oxyde de fer spinelle est une couche de magnétite ou de maghémite dopée. Avantageusement, la couche d'oxyde de fer spinelle est une couche de magnétite ou de maghémite dopée avec:

  - des métaux de transition comme par exemple : manganèse (Mn), zinc (Zn), titane (Ti), cobalt (Co), cuivre (Cu), cadmium (Cd),

  - des alcalino-terreux comme par exemple le magnésium (Mg),

  - des alcalins comme par exemple : lithium (Li), sodium (Na) et lithium (Na avec Li).

  - Ou encore, dopée avec au moins l'un parmi les éléments suivants :

    chrome (Cr), nickel (Ni), tantale (Ta), tungstène (W), rhénium (Re), osmium (Os), iridium (Ir), platine (Pt), et or (Au).

- Selon un mode de réalisation avantageux, la réalisation de la couche basale est effectuée par dépôt physique en phase vapeur (PVD).

- Selon un mode de réalisation avantageux, la réalisation de la couche d'oxyde de fer spinelle comprend un dépôt chimique en phase vapeur (CVD). De préférence, la réalisation de la couche d'oxyde de fer spinelle comprend un dépôt chimique en phase vapeur à partir de précurseurs gazeux métallo organiques (MOCVD).

- De préférence, la réalisation de la couche d'oxyde de fer spinelle comprend un dépôt chimique en phase vapeur à une température de dépôt inférieure ou égale à 450°C.

- Selon un mode de réalisation avantageux, la couche basale est au contact de la couche d'oxyde de fer spinelle. Il n'y a donc pas de couche intermédiaire entre la couche d'oxyde de fer spinelle et la couche basale.

- Selon un autre mode de réalisation avantageux, le procédé comprend, avant la réalisation de la couche d'oxyde de fer spinelle, une étape de réalisation d'au moins une couche intermédiaire sur la couche basale de sorte que la couche intermédiaire soit disposée entre la couche basale et la couche d'oxyde de fer spinelle après la réalisation de la couche d'oxyde de fer spinelle.

- Avantageusement, la couche intermédiaire est une couche d'aluminium (Al), de platine (Pl), ou de molybdène (Mo).

- Avantageusement, la couche intermédiaire présente une épaisseur inférieure à 100 nanomètres. L'invention offre néanmoins comme avantage de fonctionner dans une très large gamme d'épaisseurs pour cette couche.

- De préférence, la couche intermédiaire est au contact de la couche basale et au contact de la couche d'oxyde de fer spinelle.

Un autre aspect de la présente invention concerne un dispositif microélectronique comprenant une couche texturée de préférence selon l'axe de croissance [111] d'oxyde de fer spinelle, la couche d'oxyde de fer spinelle étant une couche de ferrite ou une couche de ferrite dopée. Le dispositif comprend une couche basale de titane (Ti) ou d'oxyde de titane ($TiO_x$) dont l'épaisseur est de préférence supérieure ou égale à huit nanomètres et sur laquelle repose la couche d'oxyde de fer spinelle.

De manière facultative, le dispositif selon l'invention peut en outre présenter au moins l'une quelconque des caractéristiques suivantes :

- Selon un mode de réalisation avantageux, la couche basale est au contact de la couche d'oxyde de fer spinelle.

- Selon un autre mode de réalisation, le dispositif comprend au moins une couche intermédiaire entre la couche basale et la couche d'oxyde de fer spinelle.

- Avantageusement, la distance entre la couche basale et la couche d'oxyde de fer spinelle est inférieure ou égale à 100 nanomètres. L'invention offre néanmoins comme avantage de fonctionner avec dans une très large gamme de distance.

- Avantageusement, le dispositif est configuré pour faire office de microbolomètre ou de mémoires non volatiles de type ferroélectrique à accès aléatoire (FeRAM), de mémoires résistives à pont conducteur (CBRAM), ou de système micromécaniques ou électromécaniques (MEMS, NEMS) ou de système optique ou optoélectronique (MOEMS) ou spintronique comprenant au moins un dispositif microélectronique selon l'invention.

Un autre aspect de la présente invention concerne un microbolomètre ou une mémoire non volatile de type ferroélectrique à accès aléatoire (FeRAM), ou une mémoire résistive à pont conducteur (CBRAM), ou un système micromécaniques ou électromécaniques (MEMS, NEMS) ou un système optique ou optoélectronique (MOEMS) comprenant au moins un dispositif microélectronique selon l'invention.

Les autres objets, caractéristiques et avantages de la présente invention apparaîtront à l'examen de la description suivante et des dessins d'accompagnement. Il est entendu que d'autres avantages peuvent être incorporés.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La FIGURE 1 montre, pour référence, un diffractogramme d'un échantillon de poudre de magnétite non texturée.
La FIGURE 2 montre le diffractogramme d'un échantillon de magnétite obtenu à partir d'une sous-couche de titane.
La FIGURE 3 montre le diffractogramme d'un échantillon de magnétite obtenu à partir d'une sous-couche d'oxyde de titane
La FIGURE 4 montre le diffractogramme d'un échantillon de magnétite où une couche intermédiaire faite de molybdène a été introduite entre la couche basale faite de titane et la magnétite.
La FIGURE 5 montre le diffractogramme d'un échantillon de magnétite où une couche intermédiaire de platine a été introduite entre la couche basale faite d'oxyde de titane et la magnétite
La FIGURE 6 est une image réalisée à l'aide d'un équipement de microscopie électronique en transmission d'une coupe d'une couche de magnétite sur une couche basale faite d'oxyde de titane.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches ne sont pas représentatives de la réalité.

DESCRIPTION DÉTAILLÉE DE L'INTENTION

Il est précisé que dans le cadre de la présente invention, le terme « sur », « surmonte » ou « sous jacent » ou leurs équivalent ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Le procédé de l'invention s'applique à l'obtention d'une couche de magnétite $Fe_3O_4$ ou de maghémite de composition chimique $Fe_2O_3$ dans sa phase dite gamma ($\gamma$-$Fe_2O_3$). L'invention s'étend aussi aux couches formées d'un mélange de magnétite et de maghémite. Comme cela sera précisé dans la suite de la description, elle couvre également le cas où la couche de ferrite est dopée.

Dans la présente demande de brevet, une couche d'oxyde de fer spinelle pourra également être désignée couche d'oxyde de fer de structure spinelle. Les oxydes de fer spinelle présentent une structure cubique face centrée (CFC). La couche peut être dopée tant que la structure spinelle (cubique CFC) n'est pas modifiée.

Par souci de clarté et de concision, dans le cadre de la présente invention, on qualifiera de « couche d'oxyde de fer spinelle » les couches suivantes : couche formée de magnétite, couche formée de maghémite, couche formée d'un mélange de magnétite et de maghémite, couche formée de maghémite dopée et/ou de magnétite dopée.

Dans la suite de la description, l'invention sera décrite plus en détail pour les modes de réalisation dans lesquels la couche d'oxyde de fer spinelle est une couche formée de l'une parmi la magnétite ou la maghémite. Néanmoins, toutes les caractéristiques et étapes de ces modes de réalisation seront applicables aux modes de réalisation dans lesquels la couche d'oxyde de fer spinelle est une couche formée de l'autre parmi la magnétite ou la maghémite ou d'une couche formée d'un mélange de magnétite et de maghémite ou encore d'une couche formée de maghémite ou de magnétite ou d'un mélange de magnétite et de maghémite et qui est dopée.

Le procédé de l'invention, décrit ci-après, permet l'élaboration de ferrite en couches minces ayant une texturation cristallographique très marquée. Comme discuté dans le chapitre sur l'état de la technique on entend ici par texturation le caractère orienté de la structure cristallographique que peuvent acquérir ces matériaux par opposition au cas, extrême, d'un matériau polycristallin présentant toutes les orientations cristallines de façon équivalente, ce qui représente le cas idéal d'une poudre. Par exemple une poudre peut être composée de grains cristallisés mais dont les grains sont orientés aléatoirement les uns par rapport aux autres. Les deux cas extrêmes de la texturation sont le monocristal et la poudre.

Le procédé de l'invention permet d'obtenir une bonne texturation de la couche d'oxyde de fer spinelle en partant d'une couche basale de titane (Ti) ou d'un oxyde de titane ($TiO_x$ ou $TiO_2$).

La couche d'oxyde de fer spinelle est déposée sur la couche basale de titane ou d'un oxyde de titane ($TiO_x$ ou $TiO_2$). C'est cette couche basale ou sous-couche qui est l'élément clef de la bonne texturation de ces matériaux.

Cette couche basale offre une large fenêtre de mise en oeuvre du procédé et permet de conserver une très bonne texturation de façon reproductible, quelle que soit la technique de dépôt employée : par exemple MOCVD ou pulvérisation comme décrit ci-après. La texturation est relativement peu dépendante des conditions de dépôt. Le pouvoir texturant de la couche basale est également indépendant des couches sous-jacentes déposées préalablement. Celles-ci peuvent être amorphes ou cristallines. Le pouvoir texturant est également indépendant des couches intermédiaires en contact direct avec les ferrites pour peu que la couche intermédiaire ne soit pas amorphe).

La texturation de la magnétite et de la maghémite s'avère être assez peu dépendante de l'état d'oxydation de la couche basale ce qui constitue un avantage et confère une souplesse supplémentaire pour la mise en oeuvre du procédé. Le fait que le titane et ses oxydes soient isolants ou conducteurs permet également une souplesse d'adaptation aux applications envisagées.

Pour que le dépôt en phase vapeur MOCVD se fasse dans de bonnes conditions on retient préférentiellement une couche basale faite de Ti, $TiO_x$ ou $TiO_2$ dont l'épaisseur est d'au moins 8 nm. Préférentiellement, on retient une épaisseur d'au moins 15 nm ce qui permet d'améliorer la qualité et la reproductibilité de la texturation. A partir de 20 nm, la qualité de la texturation n'augmente pratiquement plus avec l'augmentation de l'épaisseur de la couche basale.

Selon un mode de réalisation privilégié mais non limitatif, l'élaboration de la couche d'oxyde de fer spinelle, utilise un procédé couramment employé par l'industrie de la microélectronique qui est le dépôt chimique en phase vapeur à partir de précurseurs gazeux qui sont, dans ce cas préféré, des précurseurs métallo organiques (MO). Cette technique est désignée par son acronyme MOCVD. Ce procédé est simple à mettre en place et est peu coûteux.

La vitesse de dépôt par MOCVD de la magnétite et de la maghémite peut-être élevée. Elle est comprise typiquement dans une gamme allant de 10 à 100 nm/minute. La morphologie du film mince ainsi que sa stoechiométrie peuvent être ajustées lors du dépôt.

Le procédé de l'invention est parfaitement adapté à un usage industriel et permet un bon compromis conciliant qualité cristalline du matériau déposé, coût de fabrication et rapidité de réalisation.

Pour ce faire, le procédé utilise préférentiellement le pentacarbonyle de fer $(Fe(CO)_5)$ comme précurseur. Ce précurseur nécessite de travailler avec un gaz réactif d'oxygène $(O_2)$ afin de former les oxydes de fer. Les températures de dépôt sont alors comprises entre la limite de décomposition du précurseur qui est supérieure à 150°C et une limite supérieure qui va dépendre essentiellement de la capacité du circuit sous-jacent à supporter des températures élevées sans dommage. Typiquement, pour un circuit CMOS on se limite à 450°C. Par ailleurs on notera qu'avec une température élevée on peut constater, en fonction du précurseur choisi, la formation d'hématite ce qu'il faut éviter. On a constaté que cette température est supérieure à 500°C avec le pentacarbonyle de fer $(Fe(CO)_5)$ mentionné ci-dessus et varie en fonction des débits d'oxygène choisis. La limite inférieure de température est fixée par le précurseur lui-même. Elle est typiquement de 200°C pour le $Fe(CO)_5$ même si à partir de 150°C on peut observer une décomposition partielle. On remarquera que les températures mentionnées ci-dessus peuvent être très différentes si on utilise un autre précurseur. A titre d'exemple la température de décomposition du Fe(C5H5)2 est de 400°C et celle du Fe06C18H27 de 140°C. Ces températures ne sont cependant pas limitatives. Une augmentation de la température est un facteur favorable pour la texturation de la couche d'oxyde de fer spinelle. Il ne faut cependant pas dépasser une température au-delà de laquelle il y aurait formation d'hématite. La température de dépôt est donc choisie essentiellement en fonction de contraintes imposées par exemple par des couches sous-jacentes à la couche d'oxyde de fer spinelle. En résumé, la température est choisie pour qu'il y ait conservation de la magnétite et pour qu'elle ne provoque pas de dommage au circuit sous-jacent.

La pression dans l'enceinte est de quelques milli Torr à quelques Torr.

Une texturation préférentielle marquée suivant la direction [111] des ferrites a été observée pour une large gamme de température de dépôt comprise entre 300°C et 450°C. Cette orientation cristalline préférentielle suivant la direction [111] est également constatée pour une large fenêtre de pressions, typiquement entre 30 milli Torr et quelques Torr.

La formation de la couche basale faite de Ti est quant à elle réalisée par dépôt physique en phase vapeur ou PVD. Les conditions de dépôt peuvent se faire dans une gamme de température allant de la température ambiante à 450°C. On notera que l'industrie de la microélectronique sait mettre en oeuvre des dépôts de Ti de type PVD dans une gamme de températures allant de -20°C à 480°C

La puissance de dépôt peut varier entre 200 Watt et 12 kilo Watt. L'utilisation de puissances et de températures faibles lors des dépôts favorise la formation de couches fines à petits grains ce qui est avantageux pour l'oxydation du Ti.

L'objectif est identique qu'il s'agisse du dépôt de Ti pure ou du Ti destiné à la formation de $TiO_x$ ou de $TiO_2$. Pour la formation des oxydes de Ti, il faut procéder à une deuxième étape : le recuit oxydant. La couche déposée de Ti subit alors un recuit oxydant typiquement entre 350°C et 750°C (inférieur à 450°C pour application CMOS) suivant le type de $TiO_x$ désiré. On notera qu'entre 300°C et 750°C on obtient du $TiO_2$ rutile. Pour des températures plus basses on peut avoir un matériau moins oxydé, ou seulement en surface, plutôt de type $TiO_x$. A plus haute température on prend le risque de changer de phase : anatase, sans que cela puisse constituer une limitation dans le choix de la température cependant. La température du recuit conditionne aussi l'orientation cristalline principale qui est de (100) pour les faibles températures et (101) pour les températures élevées. Un $TiO_x$ ou $TIO_2$ formé directement lors du dépôt (par exemple par pulvérisation de Ti avec $O_2$ en gaz réactif ou MOCVD de Ti avec gaz réactif $O_2$) permettrait d'obtenir les mêmes résultats.

Il convient de rappeler que, de manière surprenante, l'orientation cristalline préférentielle de la couche d'oxyde de fer spinelle dépend peu, voire pas de l'orientation cristalline préférentielle de la couche basale. En effet, on obtient une couche d'oxyde de fer spinelle d'orientation cristalline préférentielle suivant la direction [111] alors que la couche basale peut présenter une texture (100) ou (101) par exemple. Par ailleurs, les systèmes cristallins peuvent également être différents, le $Fe_3O_4$ présente une structure cubique à faces centrées alors que le $TiO_2$ rutile présente une structure quadratique (tétragonale).

La technique de caractérisation choisie pour étudier la texturation du matériau est la diffractométrie de rayons X (DRX).

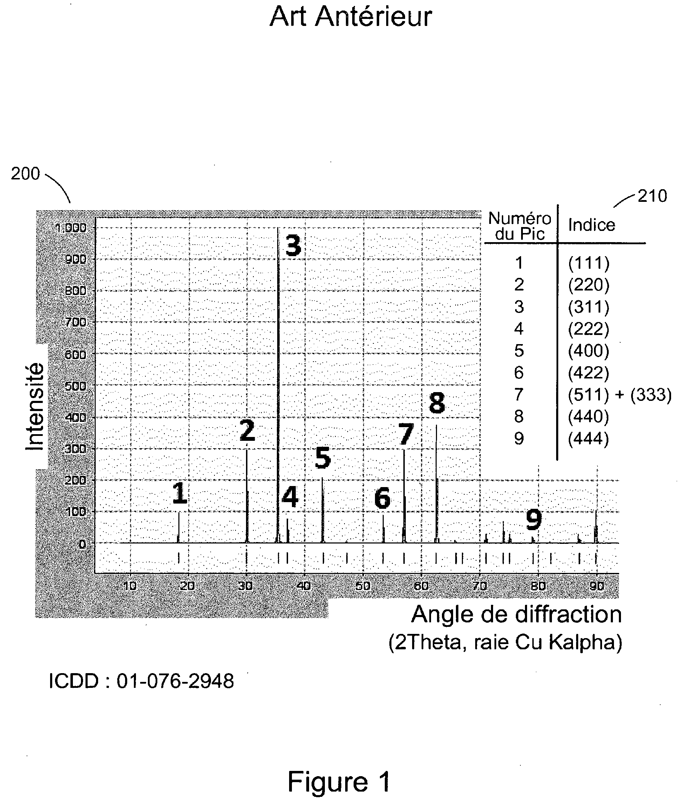

La **figure 1** montre, pour référence, un diffractogramme 200 d'un échantillon de poudre de magnétite non texturée. Ce diagramme représente d'une façon conventionnelle dans ce genre d'analyse, en ordonnée, l'intensité des pics de réflexion obtenus en fonction, en abscisse, de l'angle de diffraction (2θ) du faisceau de rayon X. On notera que 2θ est l'angle récupéré (angle entre le faisceau incident et le faisceau diffracté), θ est l'angle incident auquel l'échantillon est soumis, c'est-à-dire l'angle que forme le faisceau par rapport à la surface de l'échantillon. Comme montré sur la figure 1 l'homme du métier sait déterminer, en fonction de la position angulaire des pics, les indices de Miller 210 des plans cristallins correspondant à la structure cristalline analysée. Pour la poudre de magnétite non texturée de cet échantillon on trouve bien sûr une grande distribution des orientations cristallines. On peut noter que le diffractogramme de référence de la maghémite est très proche de celui de la magnétite. Seul un léger décalage des pics en 2Theta (dû à la légère différence de paramètre de maille), voir certains pics de surstructure peuvent être observés. D'une manière générale il est difficile de différencier la magnétite de la maghémite en diffraction de rayons X.

On notera d'ores et déjà ici qu'avec ce type de notation, des indices de Miller entièrement multiples les uns des autres correspondent à des orientations cristallines identiques. Par exemple, les indices (444), (333) et (222) présentent la même orientation cristalline que l'indice (111), soit la direction de croissance [111].

Plus précisément, le lien entre les raies ou pics de réflexion (111), (222), (333) et (444) se fait par la relation de Bragg comme suit :

$$n\lambda = 2 \, (d(hkl) \sin\theta),$$

où n est un entier, appelé l'ordre de la réflexion
$\lambda$ est la longueur d'onde de l'onde X incidente
d(hkl) est la distance interréticulaire pour des plans d'indices hkl donnés $\theta$ est l'angle de Bragg

Si on s'intéresse à l'ordre 2 (n=2) de diffraction de la raie ou pic de réflexion (111) alors :

$$2\lambda = 2d(111) \sin\theta$$

$$\lambda = 2(d(111)/2) \sin\theta$$

$$\lambda = 2d(222) \sin\theta$$

Cela implique l'existence de toutes ces raies car il n'y a pas de conditions d'extinction de celles-ci selon les plans d'indices hkl de même parité. Dans le cas d'une structure cristalline de type « cubique faces centrés » les plans d'indices (111) ou (200) diffractent mais, par exemple, pas l'orientation (210).

Les raies (111), (222), (333) et (444) proviennent des mêmes cristallites et leur présence ne traduit qu'un facteur géométrique inhérent à la relation de Bragg.

Dans le cadre de la présente invention, la direction de croissance [111] également désignée orientation cristalline préférentielle selon la direction [111], implique l'apparition de raies (111), (222), (333) et (444) etc. Les plans (111) s'empilent perpendiculairement par rapport à la normale à la surface du substrat (ou direction de croissance).

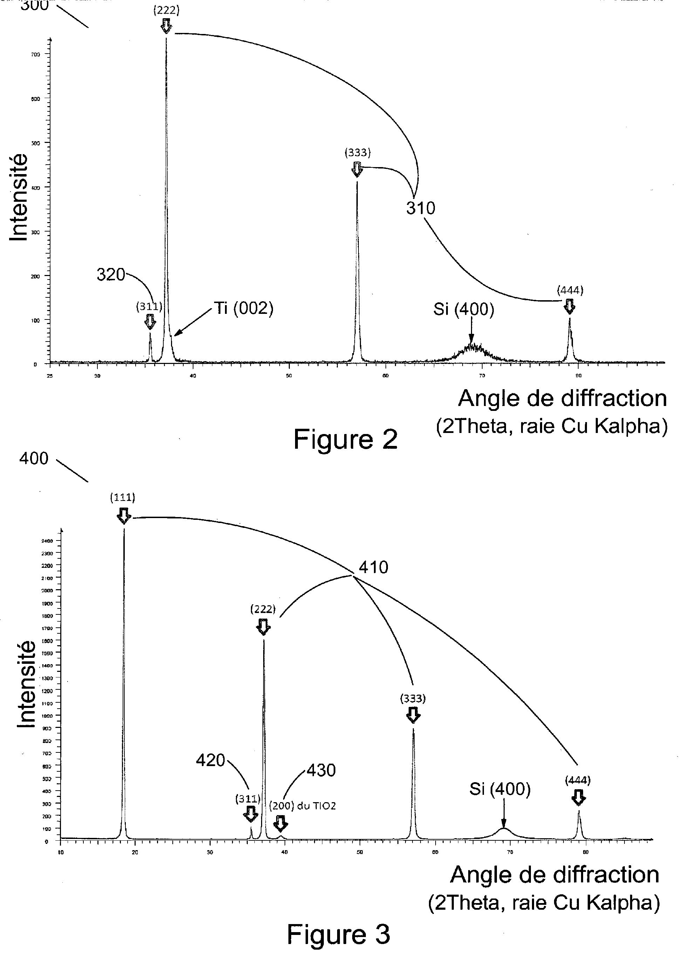

Il est important de comparer les diffractogrammes des figures suivantes, obtenus expérimentalement avec le procédé de l'invention, avec celui de référence de la figure 1. En effet, le diffractogramme de référence représente la distribution d'intensité des pics dans le cas d'un échantillon de type poudre, c'est-à-dire dont toutes les orientations cristallines sont potentiellement présentes dans des proportions sensiblement identiques. En terme de volume diffractant, il y autant de grains orientés suivant la direction [111] que de grains orientés suivant la direction [311]. Ceci permet de prendre en compte le facteur de structure de chaque raie. Ainsi, l'intensité du faisceau diffracté est décrite par une expression mathématique liant les coordonnées des atomes de la maille, leur facteur de diffusion électronique et les indices h, k, l de la famille de plans en position de diffraction (indices de Miller). Ce qui est donc important c'est de comparer l'évolution de la distribution d'intensités des pics présents dans les diffractogrammes des figures suivantes (figures 2 à 5) avec ceux du diffractogramme de référence (figure 1), et ainsi, de déterminer si une orientation cristalline devient prépondérante sur les autres en dépit des quelques incertitudes inhérentes à l'analyse de films minces texturés qui pourraient subsister.

Comme cela sera détaillé par la suite, il apparaît ainsi très distinctement sur les diffractogrammes des figures 2 à 5 que l'orientation (111) devient prépondérante par rapport à l'orientation (311) qui est pour une poudre la raie la plus intense.

La **figure 2** montre le diffractogramme 300 d'un échantillon de magnétite obtenu à partir d'une couche basale de titane (Ti) orientée (101) d'une épaisseur de 20 nm. On constate alors que la couche de magnétite qui a été déposée au-dessus sur une épaisseur de 230 nm acquiert bien une même orientation cristalline 310 qui est majoritairement l'orientation (111) puisque, comme noté ci-dessus, les raies indexées (222), (333) et (444) sont équivalentes. Seule une raie différente (311) de faible intensité 320 apparaît dans ce diagramme.

Le fait qu'on ne retrouve pas sur le diffractogramme de la figure 2 la raie (111), alors que les raies (222), (333) et (444) sont bien visibles n'est seulement dû qu'à la gamme angulaire de balayage choisie et l'angle de diffraction mesuré qui est traditionnellement noté 2θ. La raie (111) des ferrites déposées selon le procédé de l'invention est positionnée à 18.29°, en utilisant la raie Kalpha du cuivre, matériau qui constitue l'anode de l'appareillage de diffractions utilisé. Ceci fait que pour une gamme de mesures angulaires en 2θ comprise entre 25°et 89° elle ne sera pas visible même si l'orientation correspondante existe bien.

La **figure 3** montre le diffractogramme 400 d'un autre échantillon de magnétite obtenu à partir d'une couche basale d'oxyde de titane (TiO$_2$) orientée (100) d'une épaisseur de 20 nm. On constate là aussi que la couche de magnétite qui a été déposée au-dessus sur une épaisseur de 230 nm acquiert bien une même orientation cristalline 410 qui se fait majoritairement selon l'orientation (111). Comme ci-dessus, seule une orientation différente (311) de faible intensité 420 apparaît dans ce diagramme. On note aussi la présence d'un pic 430 de très faible intensité correspondant au TiO$_2$ de la sous couche.

On remarque aussi que la largeur à mi hauteur ou FWHM, acronyme de l'anglais « full width at half maximum », du pic (111) pour la magnétite déposée sur TiO$_2$ est égale à 2,15° (déterminée à l'aide d'une analyse dite « rocking curve » au cours de laquelle un mouvement de basculement est appliqué à l'échantillon), ce qui est une valeur très faible pour un film polycristallin déposé dans ces conditions. Ceci suggère que les cristallites, en plus de présenter une texturation très marquée suivant l'orientation (111), sont très peu désorientées par rapport au plan de surface de l'échantillon.

De manière particulièrement avantageuse, on a aussi observé qu'une couche intermédiaire, déposée sur le Ti, le TiO$_2$ ou plus généralement le TiO$_x$ adopte les paramètres réticulaires de cette couche basale et permet de conserver une excellente texturation de la couche d'oxyde de fer spinelle.

Cette couche intermédiaire est de préférence en contact par l'une de ses faces avec la couche basale et par l'autre de ses faces avec la couche d'oxyde de fer spinelle. La couche intermédiaire n'est pas limitée en épaisseur, ni par valeur inférieure ni par valeur supérieure. De manière préférée, la couche intermédiaire est réalisée par PVD

Alternativement, plusieurs couches intermédiaires sont disposées entre la couche basale et la couche d'oxyde de fer spinelle pour peu qu'il s'agisse de matériaux cristallins dont les paramètres cristallins sont proches.

De préférence, la couche intermédiaire est formée d'au moins l'un des matériaux suivants : molybdène (Mo), platine (Pt), Aluminium (Al). Tous les matériaux non cristallisés, donc amorphes, peuvent être exclus.

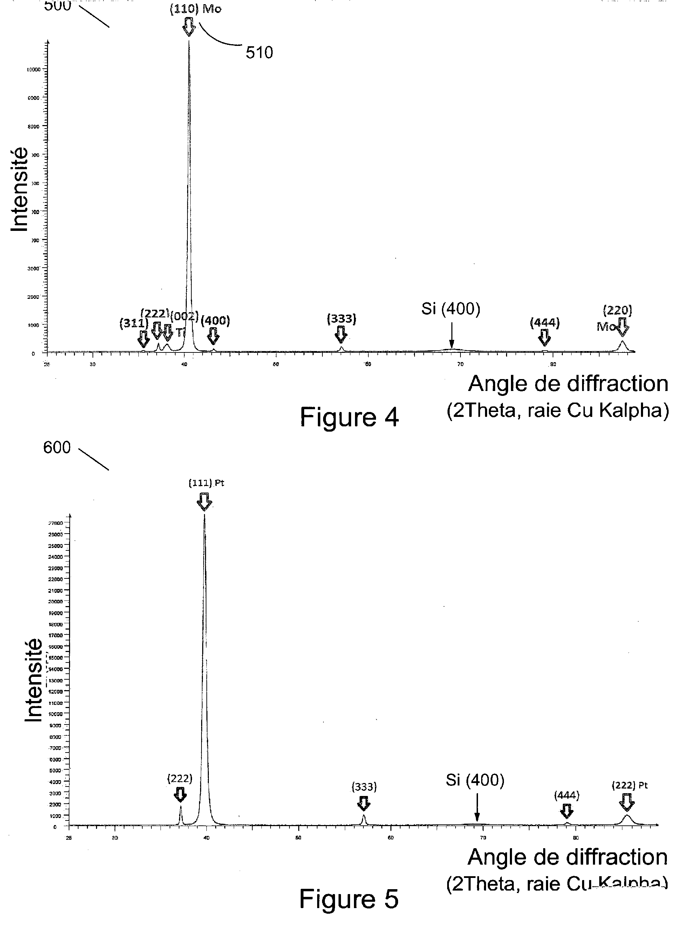

Les diffractogrammes des figures 4 et 5 montrent les résultats de texturation de la couche d'oxyde de fer spinelle obtenus avec une couche intermédiaire entre la couche basale et la couche d'oxyde de fer spinelle.

La **figure 4** montre le diffractogramme 500 d'un échantillon de magnétite où une couche intermédiaire a été introduite entre la couche basale faite de titane (Ti) et la magnétite. La couche intermédiaire est dans ce cas du molybdène (Mo). Le molybdène est texturé avec une orientation (110) par la couche de titane sous jacente d'orientation (001). La couche de magnétite a une épaisseur de 230 nm sur une sous-couche de molybdène et de titane ayant une épaisseur, respectivement, de 50 nm et de 20 nm. L'orientation préférentielle du molybdène a un pic 510 très marqué d'orientation (110).

La **figure 5** montre le diffractogramme 600 d'un échantillon de magnétite où une couche intermédiaire de platine (Pt) a dans ce cas été introduite entre la couche basale faite d'oxyde de titane (TiO$_2$) et la magnétite. Le platine est texturé suivant l'orientation. (111) par la couche d'oxyde de titane sous-jacente d'orientation (101). La couche de magnétite a une épaisseur de 230 nm sur une sous-couche de platine et d'oxyde de titane ayant une épaisseur, respectivement, de 50 nm et de 20 nm

On remarque que la texturation cristalline de la magnétite est très marquée suivant la direction [111]. Cette excellente texturation est confirmée par une FWHM très faible de 2,15° relevée sur la « rocking curve » du pic (111) de la magnétite sur TiO$_2$. On rappelera ici que (111) et (222) proviennent des mêmes grains. La valeur angulaire de 2,15° est une très bonne valeur qui signifie qu'un volume important de cristallites (grains) voient leurs plans (111) inclinés de 2,15° ou moins par rapport à la surface de l'échantillon qui est perpendiculaire à la direction de croissance.

On obtient également une couche de magnétite fortement texturée avec une orientation cristalline préférentielle selon la direction [111] en utilisant une couche basale de titane Ti et une couche intermédiaire d'aluminium (Al).

L'aluminium comme le platine ont des structures « cubic face centrées » dont le paramètre de maille est égal à la moitié de celui du Fe$_3$O$_4$ à quelques pourcentages prêt. Le tableau suivant illustre les résultats de la texturation obtenue avec et sans couche basale. Il en ressort que l'ajout de la couche basale améliore considérablement la texturation de la magnétite.

| Empilement utilisé | FWHM de la Rocking Curve | Orientation préférentielle | Autres orientations relevées |
|---|---|---|---|
| Fe$_3$O$_4$/Al(111)/Ti/SiO$_2$ (amorphe)/Si | 2.6° | (111) | (111) seulement |

(suite)

| Empilement utilisé | FWHM de la Rocking Curve | Orientation préférentielle | Autres orientations relevées |
|---|---|---|---|
| $Fe_3O/Al(111)/SiO2$ (amorphe)/Si | Elevée (supérieure à 8°) | (111) | (311) du $Fe_3O_4$, qualité cristalline de l'Al a également diminuée |
| $Fe_3O_4/Pt(1111)/TiO_2/S$ iO2 (amorphe)/Si | 2.5° | (111) | (111) seulement |
| $Fe_3O_4/Pt(111)/SiO_2$ (amorphe)/Si | 5.2° | (111) | (311) du $Fe3O_4$, qualité cristalline du Pt a également diminuée |

On remarquera aussi que la couche basale texturante doit avoir dans tous les cas une épaisseur minimale pour être efficace. Typiquement une épaisseur supérieure à 8nm et de préférence supérieure à 10nm assure une bonne texturation de la ferrite.

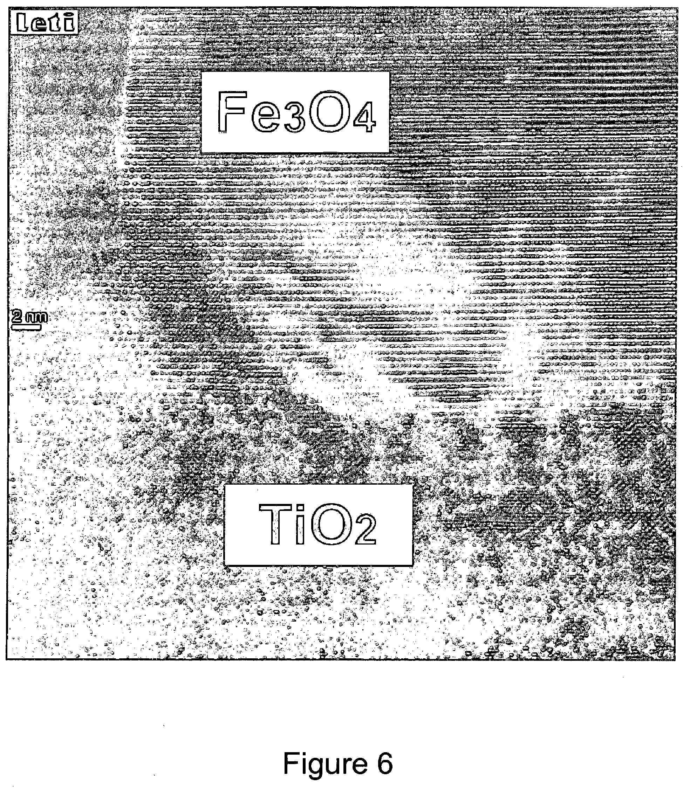

On remarquera que la magnétite obtenue est de nature polycristalline comme cela apparaît sur l'image de la **figure 6** qui a été réalisée à l'aide d'un équipement de « microscopie électronique en transmission » ou TEM de l'anglais « transmission electron microscopy ». Celle-ci révèle une grande majorité de gros grains avec une même orientation cristalline. On peut en effet voir sur cette figure les plans parallèles à la surface de $TiO_2$ de la magnétite qui sont très bien cristallisés : il n'y a pas de ruptures au niveau de l'empilement et on garde cet empilement propre et parallèle.

L'invention s'étend également aux ferrites dopées. A titre d'exemple non limitatif, une excellente texturation suivant la direction [111] est obtenue avec des couches de $Co_xFe_{3-x}O4$ et $Ni_xFe_{3-x}O4$.

Plusieurs dopants peuvent être envisagés, parmi lesquels : le manganèse (Mn), le zinc (Zn), le chrome (Cr), le nickel (Ni), le titane (Ti), le cobalt (Co), le tantale (Ta), le tungstène (W), le rhénium (Re), l'osmium (Os), l'iridium (Ir), le platine (Pt), l'or (Au).

Les dopants peuvent être présents depuis des valeurs très faibles, voire infinitésimales, jusqu'à des valeurs très élevées, supérieures à 30% atomique. Si D est l'élément dopant, le dopage est le plus souvent noté $DxFe3-xO4$ avec, en général, x compris entre 0 et 1, par exemple x=0,5. La valeur de x peut parfois être supérieure à 1. A partir de quelques pourcents on peut détecter ce dopage par EDX acronyme de l'anglais « energy dispersive X-ray spectrometry » c'est-à-dire analyse dispersive en énergie à partir de rayons-X, à l'aide d'un microscope de type MEB ou TEM. Pour des quantités plus petites il existe une panoplie de techniques pour accéder à la stoechiométrie : par émission ionique secondaire ou SIMS ; ou par spectrométrie de rétrodiffusion de Rutherford ou RBS. On peut également suivre une évolution de la stoechiométrie en fonction de la variation du paramètre de maille par incorporation d'éléments avec un rayon atomique différent qui va modifier les dimensions de la maille cristalline.

Par ailleurs, si les résultats expérimentaux ont été établis à l'aide d'échantillons obtenus par dépôt en phase gazeuse de type MOCVD toutes les méthodes de dépôt employées par l'industrie de la microélectronique sont susceptibles d'être employées pour l'obtention de la couche de ferrite. En particulier, les techniques dites IBD et PLD, mentionnées précédemment, sont susceptibles de convenir ainsi que la pulvérisation cathodique magnétron et la déposition physique en phase vapeur ou PVD.

Comme autre alternative à un dépôt par MOCVD, on peut recourir à une technique de dépôt par pulvérisation d'une cible de fer ou d'une cible du dopant, par exemple une cible de nitrure ou de cobalt, par plasma Argon et de dioxygène. On peut prévoir les conditions suivantes :

- Température du substrat: entre la température ambiante et 700°C par exemple
- Puissance de pulvérisation autour des 30W
- Pression inférieur à $10^{-3}$mbar
- Entre 2 et 5% d'oxygène par rapport à l'Argon.

On notera aussi que les dépôts de type MOCVD utilisés pour la formation de la couche de ferrite ont montré que les paramètres du procédé tels que température, pression et autres, n'ont que peu d'influence sur la texturation de la ferrite. C'est au contraire la couche basale constituée de Ti ou de ses oxydes qui s'avère être l'élément clef de la texturation de la couche de ferrites.

On notera également que les films de magnétite et de maghémite texturés intéressent potentiellement de nombreux autres domaines comme la spintronique, le magnétisme, les mémoires non volatiles dites FeRAM, les microsystèmes électromécaniques ou MEMS.

On remarquera enfin que les couches basales de titane et d'oxydes de titane sont le moteur de l'excellente texturation cristallographique de la magnétite obtenue et que les conditions de dépôt de la magnétite sont secondaires. On a noté que les grains de la magnétite s'arrangent naturellement par rapport à la couche basale faite de Ti, de $TiO_x$ ou de $TiO_2$. Le pouvoir texturant de ces couches basales est indépendant des couches antérieures au dépôt de la couche basale et des couches intermédiaires en contact direct avec les ferrites. Ceci est un avantage particulièrement important du procédé de l'invention. Un autre avantage est que l'orientation préférentielle de cette sous couche n'a que peu, voire n'a aucun effet sur la texturation (111) de la ferrite.

Les résultats obtenus sur la magnétite peuvent être extrapolés à la maghémite qui présente une structure cristalline très voisine. Le changement de phase entre la magnétite et la maghémite est une réaction topotactique. On peut donc obtenir un mélange de magnétite/maghémite sans qu'il y ait un bouleversement de la structure cristalline du film mince et de l'orientation préférentielle de ces grains. On remarquera qu'on peut passer de la magnétite à la maghémite par un recuit oxydant de la magnétite.

L'invention n'est pas limitée aux modes de réalisations précédemment décrits et s'étend à tous les modes de réalisation couverts par les revendications.

## Revendications

1. Procédé de réalisation d'une couche d'oxyde de fer spinelle texturée selon une orientation cristalline préférentielle suivant la direction [111], **caractérisé en ce qu'**il comprend :

   - la réalisation d'une couche basale de titane (Ti) ou d'oxyde de titane ($TiO_x$), l'épaisseur de la couche basale étant supérieure ou égale à huit nanomètres;
   - la réalisation d'une couche d'oxyde de fer spinelle sur la couche basale réalisée au préalable.

2. Procédé selon la revendication précédente, dans lequel l'épaisseur de la couche basale est supérieure ou égale à 10 nanomètres, de préférence supérieure ou égale à 15 nanomètres et de préférence supérieure ou égale à 20 nanomètres.

3. Procédé selon l'une quelconque des revendications précédentes, dans lequel la couche d'oxyde de fer spinelle est une couche de magnétite ($Fe_3O_4$) ou une couche de maghémite ($Fe_2O_3$) ou une couche formée d'un mélange de magnétite ($Fe_3O_4$) et de maghémite ($Fe_2O_3$).

4. Procédé selon l'une quelconque des revendications précédentes, dans lequel la couche d'oxyde de fer spinelle est une couche de magnétite dopée ou une couche de maghémite dopée ou une couche formée d'un mélange de magnétite ($Fe_3O_4$) et de maghémite ($Fe_2O_3$), le mélange étant dopé.

5. Procédé selon la revendication précédente, dans lequel l'élément dopant est pris parmi: le Manganèse (Mn), le zinc (Zn), le chrome (Cr), le nickel (Ni), le titane (Ti), le cobalt (Co), le tantale (Ta), le tungstène (W), le rhénium (Re), l'osmium (Os), l'iridium (Ir), le platine (Pt), l'or (Au), le titane (Ti), le cuivre (Cu), le cadmium (Cd), le magnésium (Mg), le lithium (Li), le chrome (Cr), le nickel (Ni), le tantale (Ta).

6. Procédé selon l'une quelconque des revendications précédentes, dans lequel la réalisation de la couche basale est effectuée par dépôt physique en phase vapeur (PVD).

7. Procédé selon l'une quelconque des revendications précédentes, dans lequel la réalisation de la couche d'oxyde de fer spinelle comprend un dépôt chimique en phase vapeur (CVD).

8. Procédé selon la revendication précédente, dans lequel la réalisation de la couche d'oxyde de fer spinelle comprend un dépôt chimique en phase vapeur à partir de précurseurs gazeux métallo organiques (MOCVD).

9. Procédé selon l'une quelconque des revendications précédentes, dans lequel la réalisation de la couche d'oxyde de fer spinelle comprend un dépôt chimique en phase vapeur à une température de dépôt inférieure à 450°C.

10. Procédé selon l'une quelconque des revendications précédentes, dans lequel la couche basale est au contact de la couche d'oxyde de fer spinelle.

11. Procédé selon l'une quelconque des revendications 1 à 9, comprenant, avant la réalisation de la couche d'oxyde de fer spinelle, une étape de réalisation d'au moins une couche intermédiaire sur la couche basale de sorte à ce que la couche intermédiaire soit disposée entre la couche basale et la couche d'oxyde de fer spinelle après la réalisation de la couche d'oxyde de fer spinelle.

12. Procédé selon la revendication précédente, dans lequel la couche intermédiaire est une couche d'aluminium (Al) ou de platine (Pt), ou de Molybdène (Mo).

13. Procédé selon l'une quelconque des deux revendications précédentes, dans lequel la couche intermédiaire est au contact de la couche basale et au contact de la couche d'oxyde de fer spinelle.

14. Dispositif microélectronique comprenant une couche d'oxyde de fer spinelle texturée selon l'axe de croissance [111], la couche d'oxyde de fer spinelle étant une couche de ferrite ou une couche de ferrite dopée, **caractérisé en ce qu'**il comprend une couche basale de titane (Ti) ou d'oxyde de titane ($TiO_x$) dont l'épaisseur est supérieure ou égale à huit nanomètres et sur laquelle repose la couche d'oxyde de fer spinelle.

15. Dispositif selon la revendication précédente, dans lequel la couche basale est au contact de la couche d'oxyde de fer spinelle.

16. Dispositif selon la revendication 14, comprenant au moins une couche intermédiaire entre la couche basale et la couche d'oxyde de fer spinelle.

17. Dispositif configuré pour faire office de microbolomètre ou de mémoires non volatiles de type ferroélectrique à accès aléatoire (FeRAM), ou de mémoires résistives à pont conducteur (CBRAM), ou de système micromécaniques ou électromécaniques (MEMS, NEMS) ou de système optique, optoélectronique (MOEMS), ou spintronique et comprenant au moins un dispositif microélectronique selon l'une quelconque des trois revendications précédentes.

## Patentansprüche

1. Verfahren zur Herstellung einer strukturierten Eisenoxidschicht vom Typ Spinell gemäß einer bevorzugten Kristallorientierung der Richtung [111] folgend, **dadurch gekennzeichnet, dass** es folgendes umfasst:

   - die Herstellung einer Titanbasalschicht (Ti) oder einer Titanoxidschicht ($TiO_x$), wobei die Dicke der Basalschicht größer/gleich acht Nanometer ist;
   - die Herstellung einer Eisenoxidschicht vom Typ Spinell auf der zuvor hergestellten Basalschicht.

2. Verfahren nach dem vorhergehenden Anspruch, in dem die Dicke der Basalschicht größer/gleich 10 Nanometer ist, vorzugsweise größer/gleich 15 Nanometer und vorzugsweise größer/gleich 20 Nanometer.

3. Verfahren nach einem der vorhergehenden Ansprüche, in dem die Eisenoxidschicht vom Typ Spinell eine Magnetitschicht ($Fe_3O_4$) oder eine Maghämitschicht ($Fe_2O_3$) oder eine Schicht bestehend aus einer Mischung aus Magnetit ($Fe_3O_4$) und Maghämit ($Fe_2O_3$) ist.

4. Verfahren nach einem der vorhergehenden Ansprüche, in dem die Eisenoxidschicht vom Typ Spinell eine dotierte Magnetit- oder eine dotierte Maghämitschicht oder eine Schicht bestehend aus einer Mischung aus Magnetit ($Fe_3O_4$) und Maghämit ($Fe_2O_3$) ist, wobei die Mischung dotiert ist.

5. Verfahren nach dem vorhergehenden Anspruch, in dem das Dotierungselement Mangan (Mn), Zink (Zn), Chrom (Cr), Nickel (Ni), Titan (Ti), Kobalt (Co), Tantal (Ta), Wolfram (W), Rhenium (Re), Osmium (Os), Iridium (Ir), Platin (Pt), Gold (Au), Titan (Ti), Kupfer (Cu), Kadmium (Cd), Magnesium (Mg), Lithium (Li), Chrom (Cr), Nickel (Ni) oder Tantal (Ta) ist.

6. Verfahren nach einem der vorhergehenden Ansprüche, in dem die Herstellung der Basalschicht durch physikalische Bedampfung in der Dampfphase erfolgt (PVD).

7. Verfahren nach einem der vorhergehenden Ansprüche, in dem die Herstellung der Eisenoxidschicht vom Typ Spinell das chemische Bedampfen in der Dampfphase umfasst (CVD).

**8.** Verfahren nach dem vorhergehenden Anspruch, in dem die Herstellung der Eisenoxidschicht vom Typ Spinell das chemische Bedampfen in der Dampfphase ausgehend von gasförmigen metallorganischen Vorläufersubstanzen (MOCVD) umfasst.

**9.** Verfahren nach einem der vorhergehenden Ansprüche, in dem die Herstellung der Eisenoxidschicht vom Typ Spinell das chemische Bedampfen in der Dampfphase bei einer Bedampfungstemperatur unter 450°C umfasst.

**10.** Verfahren nach einem der vorhergehenden Ansprüche, in dem die Basalschicht mit der Eisenoxidschicht vom Typ Spinell in Berührung ist.

**11.** Verfahren nach einem der Ansprüche 1 bis 9, das vor der Herstellung der Eisenoxidschicht vom Typ Spinell die Herstellung von zumindest einer Zwischenschicht auf der Basalschicht umfasst, so dass die Zwischenschicht nach der Herstellung der Eisenoxidschicht vom Typ Spinell zwischen der Basalschicht und der Eisenoxidschicht vom Typ Spinell liegt.

**12.** Verfahren nach dem vorhergehenden Anspruch, in dem die Zwischenschicht eine Schicht aus Aluminium (Al), Platin (Pt) oder Molybdän (Mo) ist.

**13.** Verfahren nach einem der beiden vorhergehenden Ansprüche, in dem die Zwischenschicht mit der Basalschicht und mit der Eisenoxidschicht vom Typ Spinell in Berührung ist.

**14.** Mikroelektronische Vorrichtung mit einer strukturierten Eisenoxidschicht vom Typ Spinell gemäß Wachstumsachse [111], wobei die Eisenoxidschicht vom Typ Spinell eine Ferritschicht oder eine dotierte Ferritschicht ist, **dadurch gekennzeichnet, dass** sie eine Titanbasalschicht (Ti) oder Titanoxidschicht ($TiO_x$) mit einer Dicke größer/gleich acht Nanometer umfasst, auf der die Eisenoxidschicht vom Typ Spinell aufliegt.

**15.** Vorrichtung nach dem vorhergehenden Anspruch, in dem die Basalschicht mit der Eisenoxidschicht vom Typ Spinell in Berührung ist.

**16.** Vorrichtung nach Anspruch 14, welche mindestens eine Zwischenschicht zwischen der Basalschicht und der Eisenoxidschicht vom Typ Spinell aufweist.

**17.** Vorrichtung, die so angeordnet ist, dass sie als Mikrobolometer, als nicht flüchtiger, ferroelektrischer Speicher mit wahlfreiem Zugriff (FeRAM), als resistiver Speicher mit leitfähiger Brücke (CBRAM), als mikromechanisches oder elektronmechanisches System (MEMS, NEMS), als optisches, optoelektronisches System (MOEMS) oder als spintronisches System, mit mindestens einer mikroelektronischen Vorrichtung nach einem der drei vorhergehenden Ansprüche dient.

**Claims**

**1.** A method for producing a layer of spinel iron oxide textured in a preferred crystalline orientation along the [111] direction, **characterized in that** it comprises:

- the production of a basal layer of titanium (Ti) or titanium oxide ($TiO_x$), with the thickness of the basal layer being greater than or equal to eight nanometers;
- the production of a layer of spinel iron oxide on the previously formed basal layer.

**2.** A method according to the preceding claim, wherein the thickness of the basal layer is greater than or equal to 10 nanometers, preferably greater than or equal to 15 nanometers and preferably greater than or equal to 20 nanometers.

**3.** A method according to any one of the preceding claims, wherein the layer of spinel iron oxide is a layer of magnetite ($Fe_3O_4$) or a layer of maghemite ($Fe_2O_3$) or a layer formed of a mixture of magnetite ($Fe_3O_4$) and maghemite ($Fe_2O_3$).

**4.** A method according to any one of the preceding claims, wherein the layer of spinel iron oxide is a layer of doped magnetite or a layer of doped maghemite or a layer consisting of a mixture of magnetite ($Fe_3O_4$) and maghemite ($Fe_2O_3$), with the mixture being doped.

5. A method according to the preceding claim, wherein the doping element is selected from: Manganese (Mn), zinc (Zn), chromium (Cr), nickel (Ni), titanium (Ti), cobalt (Co), tantalum (Ta), tungsten (W), rhenium (Re), osmium (Os), iridium (Ir), platinum (Pt), gold (Au), titanium (Ti), copper (Cu), cadmium (Cd), magnesium (Mg), lithium (Li), chromium (Cr), nickel (Ni), tantalum (Ta).

6. A method according to any one of the preceding claims, wherein the production of the basal layer is performed by physical vapor deposition (PVD).

7. A method according to any one of the preceding claims, wherein the production of the layer of spinel iron oxide comprises a chemical vapor deposition (CVD).

8. A method according to the preceding claim, wherein the production of the layer of spinel iron oxide comprises a chemical vapor deposition from metallo-organic gaseous precursors (MOCVD).

9. A method according to any one of the preceding claims, wherein the production of the layer of spinel iron oxide comprises a chemical vapor deposition at a deposition temperature of less than 450°C.

10. A method according to any one of the preceding claims, wherein the basal layer is in contact with the layer of spinel iron oxide.

11. A method according to any one of claims 1 to 9, comprising, prior to the production of the layer of spinel iron oxide, a step of producing at least one intermediate layer on the basal layer so that the intermediate layer is positioned between the basal layer and the layer of spinel iron oxide after the production of the layer of spinel iron oxide.

12. A method according to the preceding claim, wherein the intermediate layer is a layer of aluminum (Al) or platinum (Pt) or molybdenum (Mo).

13. A method according to any one of the preceding two claims, wherein the intermediate layer is in contact with the basal layer and in contact with the layer of spinel iron oxide.

14. A microelectronic device comprising a layer of spinel iron oxide textured along the [111] growth axis, with the layer of spinel iron oxide being a layer of ferrite or a layer of doped ferrite, **characterized in that** it comprises a basal layer of titanium (Ti) or titanium oxide ($TiO_x$), the thickness of which is greater than or equal to eight nanometers and whereon the layer of spinel iron oxide is placed.

15. A device according to the preceding claim, wherein the basal layer is in contact with the layer of spinel iron oxide.

16. A device according to claim 14, comprising at least one intermediate layer between the basal layer and the layer of spinel iron oxide.

17. A device so configured as to be used as a microbolometer or nonvolatile memories of the ferroelectric random access (FeRAM) type, or conductive-bridging resistive memories (CBRAM), or micro-mechanical or electro-mechanical systems (MEMS, NEMS) or Micro-Opto-Electro-Mechanical (MOEMS) or spintronic systems and comprising at least one microelectronic device according to any one of the preceding three claims.

# Art Antérieur

| Numéro du Pic | Indice |
|---|---|
| 1 | (111) |
| 2 | (220) |
| 3 | (311) |
| 4 | (222) |
| 5 | (400) |
| 6 | (422) |
| 7 | (511) + (333) |
| 8 | (440) |
| 9 | (444) |

Angle de diffraction
(2Theta, raie Cu Kalpha)

ICDD : 01-076-2948

## Figure 1

Figure 2

Figure 3

Figure 4

Figure 5

Figure 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Atomic and electronic structure of the Fe3O4(111)/MgO(111) model polar oxide interface. **V. K. LAZAROV ; M. WEINERT ; S. A. CHAMBERS ; M. GAJDARDZISKA-JOSIFOVSKA.** Physical Review B. The American Physical Society, 2005, vol. 72, 1-7